# EUROPEAN PATENT APPLICATION

(11) **EP 2 624 303 A1**
(43) Date of publication of application: **07.08.2013**
(21) Application number: 12184892.3
(22) Date of filing: 18.09.2012
(51) Int. Cl.: H01L 31/0224, H01L 31/048

(54) **Solar cell module and fabrication method thereof**

(30) Priority: 31.01.2012 US 201261593102 P; 14.08.2012 US 201213585821
(71) Applicant: Samsung SDI Co., Ltd., Yongin-si, Gyeonggi-do (KR)
(72) Inventor: Park, Yong-Hee, Gyeonggi-do (KR); Lee, Jeon-Il, Gyeonggi-do (KR); Yang, Jung-Yup, Gyeonggi-do (KR); Huh, Pil-Ho, Gyeonggi-do (KR); Yeo, Hyung-Sok, Gyeonggi-do (KR); Lee, Seung-Hee, Gyeonggi-do (KR)
(74) Representative: Mounteney, Simon James

(57) **Abstract**

A solar cell module including: a transparent member (24) for receiving incident light, a back sheet (22), a solar cell (1) positioned between the transparent member and the back sheet and comprising first electrodes and second electrodes (140, 150), wherein the first electrodes and the second electrodes are arranged on a side of the solar cell facing the back sheet, and an encapsulant (30) arranged to completely fill space around the solar cell (1) between the transparent member (24) and the back sheet (22). The encapsulant is formed between the first and second electrodes and insulates the first and second electrodes.

## Description

### BACKGROUND OF THE INVENTION

### (a) Field of the Invention

The present invention relates to a solar cell module and a fabrication method thereof, and more particularly, to a back contact solar cell module and a fabrication method thereof.

### (b) Description of the Related Art

Recently, a solar cell has been developed as an interdigitated back contact solar cell in which electrodes for collecting electrons and holes are positioned on a rear surface of a substrate in order to increase a light incident area.

In such back contact solar cells, n electrodes (or first electrodes) and p electrodes (or second electrodes) are cross-aligned in respective lines of the back contact solar cell, and in order to obtain predetermined power, a plurality of solar cells are connected to form a module.

Here, the solar cells are connected by ribbons, and in order to prevent shunt between the first and second electrodes on the rear surface thereof, an insulating material layer is formed.

The above information disclosed in this Background section is only for enhancement of understanding of the background of the invention and therefore it may contain information that does not form the prior art that is already known in this country to a person of ordinary skill in the art.

### SUMMARY OF THE INVENTION

However, the insulating material layer acts as a loss factor hampering a current flow in connecting the metal ribbons, degrading an output according to an increase in resistance. Thus, in order to reduce resistance, a metal ribbon, a first electrode, and second ribbons are required to be formed to be thick. However, the increase in the thickness increases a probability in which a cell is damaged in a lamination process of the module. In addition, the first and second electrodes, which are formed on the same surface of the inerdigitated back contact solar cell, have to be insulated from each other, and the gap between the first electrode and the second electrode is very narrow, and thus a process for forming an insulating layer becomes complicated.

Thus, the present invention has been made in an effort to provide a solar cell module and a fabrication method thereof having advantages of minimizing damage of cells by easily connecting the cells without increasing a thickness of ribbons and changing a shape, and reducing a process and costs for fabricating ribbons.

An embodiment of the present invention provides a solar cell module including: a transparent member for receiving incident light, a back sheet, a solar cell positioned between the transparent member and the back sheet and comprising first electrodes and second electrodes, wherein the first electrodes and the second electrodes are arranged on a side of the solar cell facing the back sheet, and an encapsulant arranged to completely fill space around the solar cell between the transparent member and the back sheet. Here, the encapsulant is formed between the first and second electrodes and insulated the first and second electrodes. The first and second electrodes of the solar cell may be electrically connected by a ribbon having a predetermined thickness, respectively.

Another embodiment of the present invention provides a method of manufacturing a solar cell module including: forming a first encapsulation layer by applying liquefied uncured-encapsulant on to a transparent member, and providing a solar cell on the first encapsulation layer, so as to fill the gap between the first electrode and the second electrode with the liquefied uncured-encapsulant by capillary phenomenon.

According to a first aspect of the invention, there is provided a solar cell module as set out in claim 1. Preferred features of this aspect are set out in claims 2 to 7.

The solar cell module may further comprise a second solar cell, wherein each solar cell comprises first electrodes and second electrodes, wherein the electrodes in the first and second solar cells having the same polarity are connected to each other, wherein the sealing layer is arranged to completely fill space between the first solar cell and the second solar cell.

In some embodiments, the first solar cell and the second solar cell are electrically connected via a ribbon. In some embodiments, contact members are formed in electrical contact with the first electrodes and second electrodes, wherein the ribbon connects to said electrodes via the contact members. In some embodiments, the solar comprises a bus bar arranged to contact the first electrodes and second electrodes, wherein the contact members are formed on the bus bar.

In some embodiments, the first solar cell and the second solar cell are electrically connected via a printing wiring board. In some embodiments, contact members are formed on the first electrodes and second electrodes, wherein the printing wiring board connects to said electrodes via the contact members.

In some embodiments, the solar cell module further comprises a frame.

In some embodiments, the sealing layer may comprise a first encapsulant layer arranged to contact the transparent member and a second encapsulant layer formed around the first solar cell and arranged to contact the back sheet. In other embodiments, the sealing layer may comprise a single encapsulant layer formed around the first solar cell, the single encapsulant layer arranged to contact the transparent member and the back sheet. In other embodiments still, the solar cell module may further comprise an optical layer arranged to contact the transparent member, wherein the first solar cell contacts the optical layer, and the sealing layer is arranged to contact the optical layer and the back sheet.

In some embodiments, the sealing layer is formed from a cured liquid phase encapsulant.

In some embodiments, the sealing layer is formed from an encapsulant comprising a silicone based material. In some embodiments, the encapsulant comprises any one or combination of resins such as polysilicone, polyolephine, polyurethane, ionomer, urea, epoxy, acryl resin.

According to a another aspect of the invention, there is provided a method of manufacturing a solar cell module as set out in claim 8. Preferred features of this aspect are set out in claims 9 to 15.

According to some embodiments of the present invention, when the solar cell is sealed by using liquefied encapsulant, a process of forming an insulating layer and forming a contact hole on the insulating layer can be omitted, simplifying the process of manufacturing a solar cell module.

Also, since there is no need to perform a process of inserting a protrusion of a ribbon into a contact hole, production costs associated with the ribbons a contact hole are not incurred and a defect otherwise generated by inserting a ribbon into a contact hole is not generated.

Thus, cells can be prevented from being damaged during a lamination process.

### BRIEF DESCRIPTION OF THE DRAWINGS

FIG. 1 is a schematic cross-sectional view of a solar cell module according to an embodiment of the present invention.
FIG. 2 is an enlarged plan view showing a portion of a solar cell module according to an embodiment of the present invention.
FIG. 3A is a cross-cross-sectional view taken along line III-III in FIG. 2.
FIG. 3B and FIG. 3C are cross-cross-sectional views according to a variation of the solar cell module shown in FIG. 3A.
FIG. 4 is a schematic cross-sectional view of a solar cell according to an embodiment of the present invention.
FIG. 5 is a flow chart illustrating the process of a method for fabricating a solar cell module according to an embodiment of the present invention.
FIG. 6 is a schematic cross-sectional view of a solar cell module according to another embodiment of the present invention.
FIG. 7 is a schematic cross-sectional view of a solar cell module according to another embodiment of the present invention.

### DETAILED DESCRIPTION OF THE EMBODIMENTS

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

A solar cell module and a fabrication method thereof according to an exemplary embodiment of the present invention will be described with reference to the accompanying drawings.

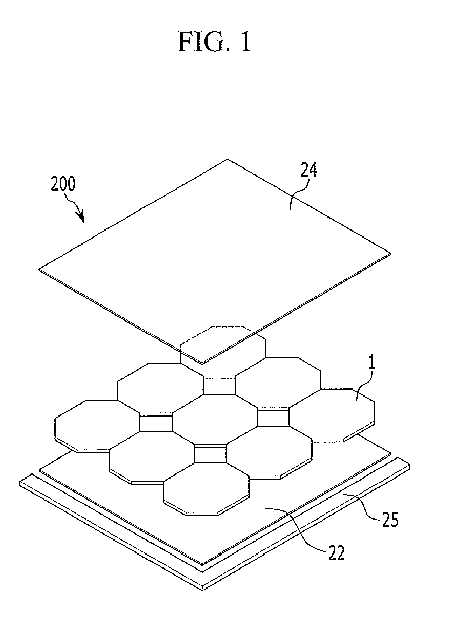

FIG. 1 is a schematic cross-sectional view of a solar cell module according to an embodiment of the present invention.

As shown in FIG. 1, a solar cell module 200 according to an embodiment of the present invention includes a transparent member 24, solar cells 1, and a back sheet 22 sequentially stacked therein. A space between the transparent member 24 and the back sheet 22 is filled with an encapsulant formed by curing the liquefied curable material to completely seal the solar cells, and a frame 25 accommodates these elements.

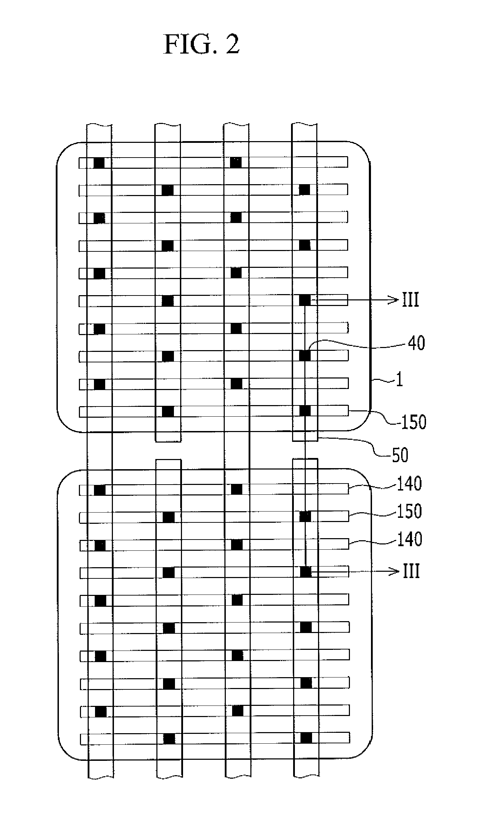

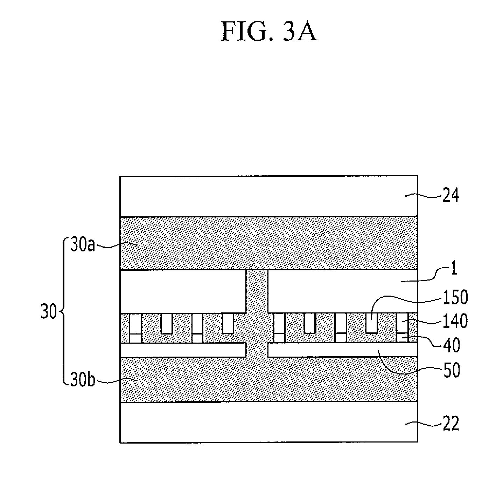

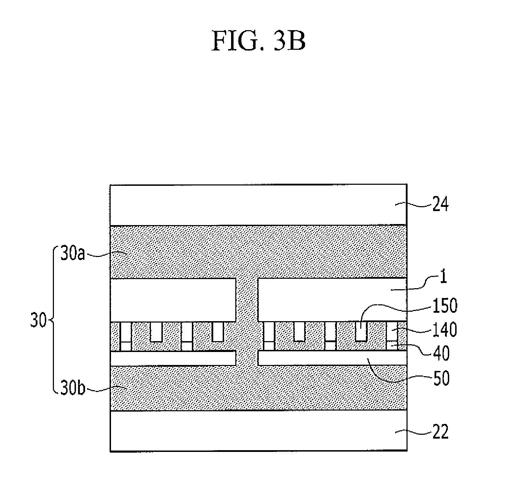

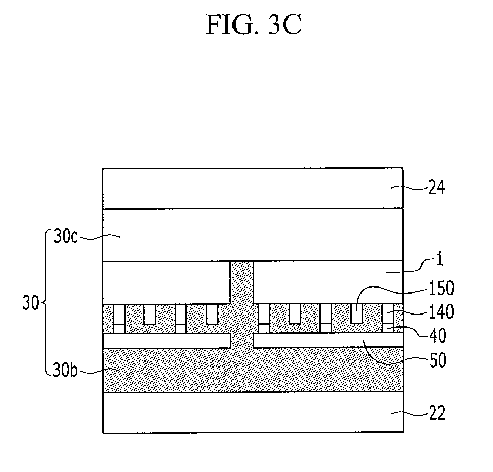

The solar cell module according to an embodiment of the present invention will be described in detail with reference to FIGS. 2 and 3A, 3B and 3C.

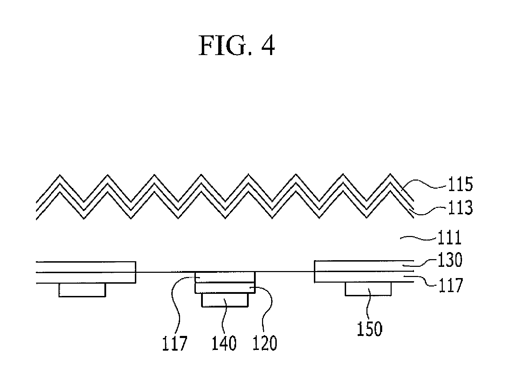

FIG. 2 is an enlarged plan view showing a portion of a solar cell module according to an embodiment of the present invention. FIG. 3A is a cross-cross-sectional view taken along line III-III in FIG. 2, and FIGS. 3B and 3C are variations of the solar cell module shown in FIG. 3A according to other embodiments of the invention. FIG. 4 is a schematic cross-sectional view of a solar cell according to an embodiment of the present invention.

As shown in FIGS. 2 and 3A, the solar cell module according to an embodiment of the present invention includes the transparent member 24, a plurality of solar cells 1 disposed on the transparent member 24, and a back sheet 22 disposed on the solar cells 1. The solar cells are completely sealed by an encapsulant 30.

The transparent member 24 is made of a material which has high light transmission and is processed to lower a loss of surface reflection to reduce a loss of light absorption. For example, the transparent member 24 may be made of glass. In order to enhance transmittance, preferably, the content of iron is reduced (or minimized), and in order to strengthen mechanical strength, preferably, tempered glass which has undergone a thermal treatment is used in some embodiments.

An inner surface of the transparent member 24 may be embossed to have an enhanced diffusion effect.

As shown in FIG. 4, the solar cell includes a conductive type semiconductor substrate 111, a front surface field (FSF) 113 formed on one surface, e.g., a light receiving surface, of the semiconductor substrate 111, and an anti-reflective film 115 formed on the FSF 113.

The light receiving surface of the semiconductor substrate 111 may be formed as a textured surface including a plurality of prominences and depressions. Here, the FSF 113 and the anti-reflective film 115 also have prominences and depressions formed along the textured surface.

The semiconductor substrate 111 may be doped with a second conductive impurity, and the second conductive impurity may be an n type impurity or a p type impurity. The n type impurity may include impurities of pentavalent elements such as phosphorus (P), arsenic (Ar), antimony (Sb), and the like. The p type impurity may include impurities of trivalent elements such as boron (B), gallium (Ga), indium (In), and the like.

The textured surface of the semiconductor substrate 111 serves to increase a light absorption rate to enhance efficiency of the solar cells.

The FSF 113 is a film obtained by doping with a second conductive impurity, at a higher density than that of the semiconductor substrate 111, in which electrons and holes separated by incident light can be prevented from becoming extinct after being recombined on the light receiving surface of the semiconductor substrate 111.

The anti-reflective film 115 formed on the FSF 113 is formed of a silicon nitride film (SiNx), a silicon oxide film (SiO₂), or the like. The anti-reflective film 115 serves to reduce reflectivity of incident solar cell and increase selectivity of a particular wavelength region to thus enhance efficiency of the solar cells.

Meanwhile, the solar cell includes a rear protective film 117 formed on the other surface, i.e., on a rear surface of the semiconductor substrate 111, a first doped region 120 including a first conductive impurity doped at a high density therein, a second doped region 130 formed on the semiconductor substrate 111 under the rear protective film 117 and including a second conductive impurity doped at a high density therein, a first electrode 140 formed on the first doped region 120, and a second electrode 150 positioned on the rear protective film 117 corresponding to the second doped region 130.

The first conductive impurity is doped with high density in the first doped region 120 formed on the rear surface of the semiconductor substrate 111, and the second conductive impurity is doped with higher density than that of the semiconductor substrate 111 in the second doped region 130. Thus, when the p type impurity is doped in the first doped region 120 and the n type impurity is doped in the semiconductor substrate 111, the first doped region 120 and the semiconductor substrate 111 form a p-n junction.

The first doped region 120 and the second doped region 130 act as transfer paths of carriers (holes or electrons), and serve to allow the holes and electrodes to be collected toward the first doped region 120 and the second doped region 130.

The rear protective film 117 is formed of a silicon oxide film (SiO₂), a silicon nitride film (SiNx), or a combination thereof.

The rear protective film 117 serves to prevent carriers separated into electrons and holes from being recombined, and reflect incident light to the interior of the solar cells to prevent a loss of light to the outside, namely, thus reducing the amount of light lost to the outside. The rear protective film 117 may be formed as a single film, or may have a multi-layered structure such as dual-layer or triple-layer.

The first electrode 140 is electrically connected to the first doped region 120, and the second electrode 15 is electrically connected to the second doped region 130. The first electrode 140 and the second electrode are formed to be spaced apart.

With reference back to FIGS. 2 and 3A, the first electrode 140 and the second electrode 150 extend in one direction and are alternately disposed. The distance of the first electrode 140 and the second electrode 150 may be less than about 5mm, for example about 100nm to about 1mm.

Contact members 40 made of a conductive material are formed on the first electrode 140 and the second electrode 150. Ribbons 50 are formed on the contact members 40. The ribbons 50 electrically connect electrodes having the same polarity, such as the first electrodes 140 or the second electrodes 150 through the contact members 40, and connect neighboring cells in series.

The back sheet 22 serves to prevent moisture infiltrating from the rear surface of the module to protect the solar cells against an external environment. As the back sheet 22, a sheet which has excellent insulating characteristics and durability to lengthen a life span of the solar cell module and is configured to include, for example, FP/PE/FP (fluoropolymer-polyeaster-fluoropolymer) layers may be used. Here, as the back sheet 22 is thinner, it may have excellent sealing characteristics, but in this case, the durability may be reduced and the back sheet may be damaged by external impact. Thus, the back sheet 22 may have a thickness ranging from 0.1 mm to 0.2 mm.

Meanwhile, the solar cells 1 are completely sealed by the encapsulant 30. A space between the back sheet 22 and the solar cells 1, and the space between the first electrode 140 and the second electrode 150 is filled with the encapsulant 30.

The encapsulant 30 serves to prevent the first electrode 140 and the second electrode 150 from being corroded by moisture infiltrating when the solar cell module is exposed to the outside for a long period of time. Further, the encapsulant 30 formed between the first electrode 140 and the second electrode 150 can absorb impacts from the outside so as to protect the first and second electrodes 140, 150. Furthermore, the encapsulant 30 can protect the solar cells 1 from exterior impact. For effectively absorbing the impact, the encapsulant 30 may have low modulus of elasticity, for example, 10∼200GPa, and the encapsulant 30 may have a tensile strength of about 1psi to about 500psi.

The encapsulant 30 is positioned in a path of light made incident to the solar cell 1, so in order to enhance a light absorption of the solar cell 1, the encapsulant 30 is made of a material having a transmittance of 90% or more, for example 97% or more, in a wavelength range of 400 nm to 1,200 nm. Also, the encapsulant 30 may be made of a curable material. Accordingly, the encapsulant 30 may be formed by applying a liquid material and then curing it. The detail of the method for forming the encapsulant 30 is described later.

For example, the curable material may include resins such as polysilicone, polyolephine, polyurethane, ionomer, urea, epoxy, acryl resin, and the like. Other embodiments may use other materials.

Especially, the polysilicone, which is able to absorb a short wavelength up to 250 nm, increases incident light of the solar cells, thus enhancing the efficiency of the solar cells.

The encapsulant 30 may be formed between the transparent member 24 and the solar cells 1. That is, the encapsulant 30 in some embodiments includes a first encapsulation layer 30a, which is formed between the transparent member 24 and the solar cells 1, and a second encapsulation layer 30b, which is formed between the back sheet 22 and the solar cells 1, and between the first electrode 140 and the second electrode 150. However, as shown in FIG. 3B, the encapsulation layer 30 may be configured as a single encapsulation layer according to a filling method. Otherwise, as shown in FIG. 3C, the encapsulation 30 may just include the second encapsulation layer 30b, and an optical layer (30c), such as an EVA (ethylene vinyl acetate) layer, may be separately formed between the transparent member 24 and the solar cells 1.

Also, in an embodiment of the present invention, the first encapsulation layer 30a and the second encapsulation layer 30b are made of silicone having the same properties, but here, the first encapsulation layer 30a may be made of transparent material having transmittance of 90% or more and the second encapsulation layer 30b may be made of white material including white pigment. When the second encapsulation layer 30b is made of white material, light incident from the front surface can be reflected to be made incident to the cells, increasing luminous efficiency.

The method for fabricating a solar cell module as mentioned above will be described in detail with reference to FIGS. 2, 3A, 3B, 3C, and 5.

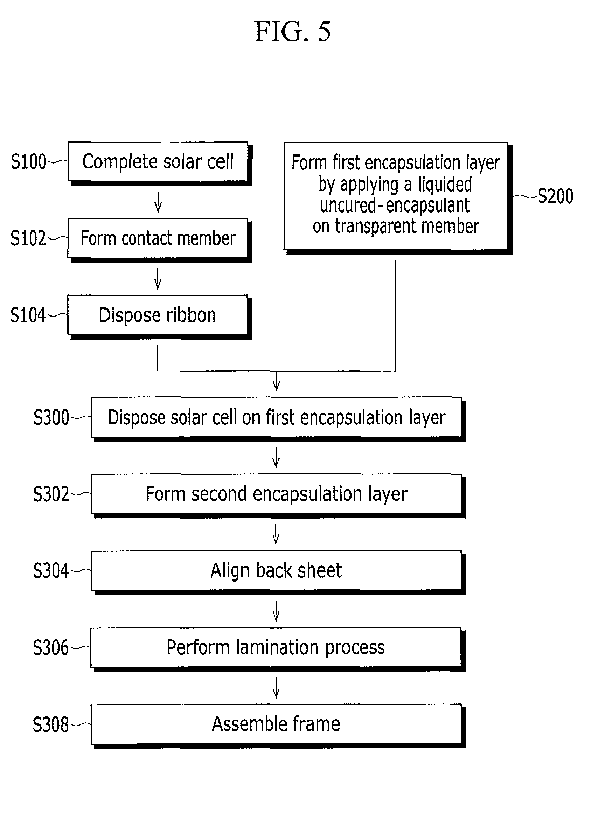

FIG. 5 is a flow chart illustrating the process of a method for fabricating a solar cell module according to an embodiment of the present invention.

With reference to FIG. 5, first, a plurality of solar cells 1 as shown in FIG. 4 are completed (S100).

The contact members 40 are formed on the first electrode 140 and the second electrode 150 of the solar cell 4 (S102).

The contact members 40 may be formed by using a direct printing method such as inkjet printing, electrohydrodynamic jet printing, offset printing, gravure printing, flexo printing, aerosol jet printing, or the like, which does not use a mask, as well as an indirect printing method such as screen printing which uses a mask. Here, the thickness of a conductive layer can be adjusted by repeating the number of times of printing.

Thereafter, the ribbons 50 connecting the contact members 40 of the first electrodes 140 and the contact members 40 of the second electrodes 150 are disposed (S104) and then soldered to electrically connect the neighboring cells 1. Here, the cells are disposed in a row and then electrically connected by the ribbons. The ribbons 50 may be made of tin, silver, lead, or the like.

In the soldering process, a flux serving as an adhesive is coated, and then, radiant heat energy of a high intensity lamp is applied thereto or heated air is jetted thereto.

And then, the first encapsulation layer 30a is formed on the transparent member 24 by applying the liquefied uncured-encapsulant (S200). The uncured-encapsulant may be coated through a method such as spin coating, or the like.

The group of a plurality of cells connected in a row is arranged in a matrix form on the first encapsulation layer 30a (S300).

Here, the uncured-encapsulant is injected to a narrow gap between the first electrode 140 and the second electrode 150 according to a capillary phenomenon to fill the space between the first electrode 150 and the second electrode 150.

Preferably, the uncured-encapsulant may have viscosity ranging from 2 cps to 5,000 cps, more preferably from 5 cps to 20 cps to easily fill the gap between the first electrode 140 and the second electrode 150.

Thereafter, the uncured-encapsulant is further coated to cover the solar cells 1 to form the second encapsulation layer 30b (S302). At this time, when the uncured-encapsulant for the second encapsulation layer is different from the liquefied uncured-encapsulant for the first encapsulation layer, the first and second encapsulation layer (30a, 30b) are formed as separate layers from each other, as shown in FIG. 3A. Meanwhile, when the uncured-encapsulant for the second encapsulation layer is the same as the liquefied uncured-encapsulant for the first encapsulation layer, the first and second encapsulation layers (30a, 30b) are formed as a single encapsulation layer, as shown in FIG. 3B.

In this manner, the gap between the first electrode 140 and the second electrode 150 can be easily filled by using the liquefied uncured-encapsulant according to an embodiment of the present invention. Accordingly, the first electrode 140 and the second electrode 150 can be insulated without having to form an insulating layer, thereby simplifying the process of forming the solar cell module.

Thereafter, the back sheet 22 is aligned on the second encapsulation layer 30b (S304). And, a lamination process of applying predetermined heat and pressure is performed (S306) to integrate the transparent member, the solar cells, and the back sheet. Then, the first encapsulation layer and the second encapsulation layer are hardened (or cured) to fix the transparent member, the solar cells, and the back sheet in conjunction. Here, the lamination process is performed at a curing temperature of the uncured-encapsulant. Preferably, when polysilicon is used as the encapsulant, it may be cured at a temperature of 100°C or lower, within 15 minutes. When polyolefin is used as the encapsulant, it may be cured at a temperature of 150°C or higher for 15 to 30 minutes.

After the curing operation, the encapsulant has viscosity ranging from about 2,000 cps to about 100,000cps, completely fixing and sealing the solar cells.

In comparison to a related art sealing member, the liquefied uncured-encapsulant has a lower curing temperature and shorter curing time, so it can contribute to simplify the fabrication process of the solar cells.

Thereafter, the frame 25 is disposed at the edges of the lamination process-finished module and then assembled (S308) to complete the solar cell module.

According to the such embodiments, the insulation of the first and second electrode and the sealing of the solar cell module are accomplished at the same time by using the liquefied uncured-encapsulant, and thus the process of fabricating the solar cells can be simplified. And a process of forming a contact hole in an insulating layer in order to connect the ribbon and the first electrode or the ribbon and the second electrode can be omitted.

Namely, the process of forming ribbons such that a ribbon at the portion (referred to as a 'protrusion', hereinafter) positioned in the contact hole is formed to be thicker than a ribbons at the portion positioned in a different portion in order to insert the ribbon into the contact hole, as in the related art, is omitted, thus reducing fabrication costs and time.

Also, since the protrusion is not formed, eliminating a difference in thickness, a flat plate type ribbon having a predetermined thickness can be used, and thus, pressure applied to the solar cells during the lamination process can be reduced. Accordingly, damage to the solar cells can be minimized.

Also, since the process of aligning the protrusion of the ribbon and the contact hole in order to insert the protrusion of the ribbon into the contact hole is omitted, the process of fabricating the solar cells can be simplified and a defect due to misalignment between the protrusion of the ribbon and the contact hole is not generated.

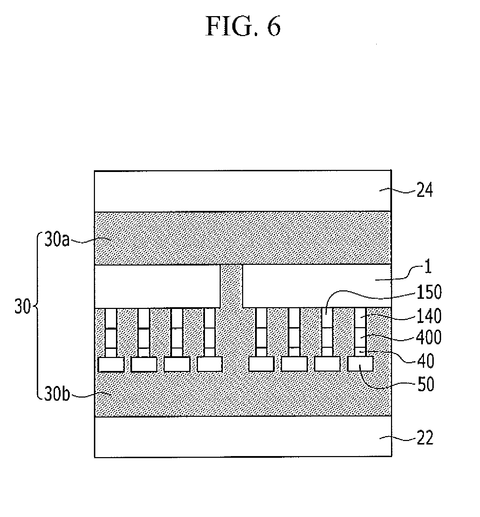

FIG. 6 is a schematic cross-sectional view of a solar cell module according to another embodiment of the present invention.

The interlayer configuration of the solar cell module of FIG. 6 is the same as that of the solar cell module of FIG. 2, so only different portions will be described in detail. Like reference numerals are used for like elements,

As shown in FIG. 6, the solar cell module according to an embodiment of the present invention includes the transparent member 24, the solar cells 1, and the back sheet 22 stacked therein. The encapsulant 30 formed by curing the liquefied curable material is formed between the transparent member 24 and the back sheet 22.

The first and second electrodes of the solar cells of FIG. 6 are electrically connected by bus bars 400, respectively.

The contact members 40 are formed on the bus bars 400, and ribbons 50 are formed on the contact members 40. The formation of the bus bars 400 can reduce the thickness of the contact members 40.

In an embodiment of the present invention, since a gap between ribbons and a gap between the first and second electrodes are completely sealed with silicon, although the width of the ribbons is increased, the ribbons can be prevented from colliding with the first or second electrode or neighboring ribbons can be prevented from being in contact. Thus, a loss of current generated in the cells can be minimized by increasing the width of the ribbons to its maximum level.

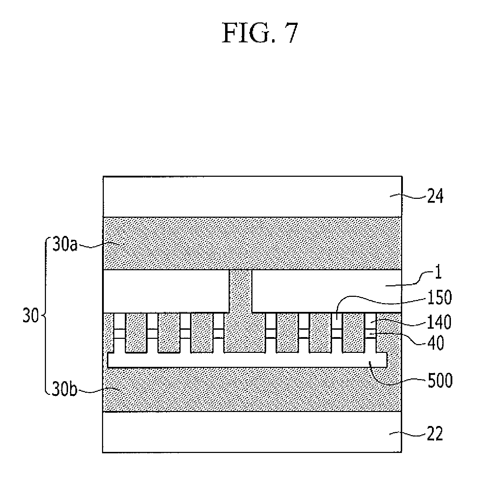

FIG. 7 is a schematic cross-sectional view of a solar cell module according to another embodiment of the present invention.

The interlayer configuration of the solar cell module of FIG. 7 is the same as that of the solar cell module of FIG. 2, so only different portions will be described in detail. Like reference numerals are used for like elements.

As shown in FIG. 7, the solar cell module according to an embodiment of the present invention includes the transparent member 24, the solar cells 1, and the back sheet 22 stacked therein. The encapsulant 30 formed by curing the liquefied curable material is formed between the transparent member 24 and the back sheet 22.

Unlike the case illustrated in FIGS. 2 and 6, the solar cell module of FIG. 7 is configured such that the first electrode 140 and the second electrode 150 are connected by a printing wiring board (PWB) 500.

With reference to FIG. 7, the contact members 40 are formed on the first electrode 140 and the second electrode 150 of the solar cells 1. The contact members 40 are connected by the PWB 500,

Wirings of the PWB 500 are arranged in the same manner as that of the first electrodes 140 and the second electrodes 150 of the solar cells 1.

The formation of the PWB 500 according to an embodiment of the present invention can contribute to reduce the thickness of the first and second electrodes in their formation, so the fabrication costs for forming cells can be reduced. Also, since a current path is formed through the PWB, an effect of increasing a cell-to-module (CMT) CR can be obtained.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A solar cell module (200) including:
a transparent member (24) for receiving incident light;
a back sheet (22);
a first solar cell (1) comprising first electrodes (140) and second electrodes (150), wherein the first electrodes (140) and second electrodes (150) are arranged on a side of the first solar cell (1) facing the back sheet (22);
a sealing layer arranged to completely fill space between the first electrodes (140) and second electrodes (150) of the first solar cell (1) and between the first solar cell (1) and the back sheet (22), wherein the sealing layer is formed from a cured liquid phase encapsulant.

2. A solar cell module according to claim 1, further comprising a second solar cell (1), wherein the second solar cell (1) comprises first electrodes (140) and second electrodes (150), wherein the electrodes in the first and second solar cells (1) having the same polarity are electrically connected to each other, wherein the sealing layer (30) is arranged to completely fill space between the first electrodes (140), second electrodes (150) of the second solar cell (1) and between the second solar cell (1) and the back sheet (22), and between the first solar cell and the second solar cell.

3. A solar cell module according to claim 1 or 2, wherein the sealing layer (30) comprises a first encapsulant layer (30a) arranged to contact the transparent member (24) and a second encapsulant layer (30b) formed around the first solar cell (1) and arranged to contact the back sheet (22).

4. A solar cell module according to claim 1 or 2, wherein the sealing layer (30) comprises a single encapsulant layer formed around the first solar cell (1), the single encapsulant layer arranged to contact the transparent member (24) and the back sheet (22).

5. A solar cell module according to claim 1 or 2, further comprising
an optical layer (30c) arranged to contact the transparent member (24), wherein the first solar cell (1) contacts the optical layer, and the sealing layer is arranged to contact the optical layer (30c) and the back sheet (22).

6. A solar cell module according to any one of claims 1 to 5, wherein the sealing layer is formed from a silicone based material.

7. A solar cell module according to any one of claims 1 to 6, wherein the encapsulant comprises any one or combination of resins such as polysilicone, polyolephine, polyurethane, ionomer, urea, epoxy, acryl resin.

8. A solar cell module according to any one of claims 1 to 7, wherein the sealing layer (30) has modulus of elasticity of about 10GPa to about 200 GPa, and a tensile strength of about 1 psi to about 500 psi.

9. A method of manufacturing a solar cell module including:
providing a transparent member (24);
providing a first solar cell (1) comprising first electrodes (140) and second electrodes (150);
applying a liquid phase encapsulant so as to completely fill space between the first electrodes (140) and second electrodes (150) of the first solar cell (1);
forming a back sheet (22) on the encapsulant;
curing the encapsulant to form a sealing layer between the first electrodes (140) and second electrodes (150) of the first solar cell (1) and between the first solar cell (1) and the back sheet (22).

10. A method of manufacturing a solar cell module according to claim 9, wherein the encapsulant comprises a first encapsulant layer (30a) and a second encapsulant layer (30b), the method comprising:
applying a liquid phase encapsulant so as to form the first encapsulant layer (30a) on the transparent member (24);
providing the first solar cell (1) on the first encapsulant layer (30a);
forming the second encapsulant layer (30b) on the first solar cell (1);
forming the back sheet (22) on the second encapsulant layer (30b).

11. A method of manufacturing a solar cell module according to claim 9, further comprising:
forming an optical layer (30c) on the transparent member (24);
providing the first solar cell (1) on the optical layer (30c);
forming the sealing layer on the first solar cell (1);
forming the back sheet (22) on the encapsulant, wherein the sealing layer is arranged to contact the optical layer (30c) and the back sheet (22).

12. A method of manufacturing a solar cell module according to any one of claims 9 to 11, comprising connecting the first solar cell (1) to a second solar cell (1) prior to applying the liquid phase encapsulant, wherein the electrodes in the first and second solar cells (1) having the same polarity are electrically connected to each other, and wherein the liquid phase encapsulant is arranged to fill space between the first electrodes (140) and second electrodes (150) of the second solar cell (1) and between the first solar cell and the second solar cell.

13. A method of manufacturing a solar cell module according to any one of claims 9 to 13, wherein the liquid phase encapsulant has viscosity ranging from 5 cps to 20 cps.

14. A method of manufacturing a solar cell module according to any one of claims 9 to 13, wherein the encapsulant comprises a silicone based material.

15. A method of manufacturing a solar cell module according to any one of claims 9 to 14, wherein the encapsulant comprises any one or combination of resins such as polysilicone, polyolephine, polyurethane, ionomer, urea, epoxy, acryl resin.
